# DEMANDE DE BREVET EUROPEEN

(11) **EP 1 635 626 A2**
(43) Date de publication de la demande: **15.03.2006**
(21) Numéro de dépôt: 05291836.4
(22) Date de dépôt: 06.09.2005
(51) Int. Cl.: H05K 7/12, F21V 19/00

(54) **Dispositif support pour un dispositif d'éclairage et/ou de signalisation de véhicule automobile**

(30) Priorité: 10.09.2004 FR 0409641
(71) Demandeur: VALEO VISION, 93012 Bobigny Cédex (FR)
(72) Inventeur: Cabanne, Damien, 89100 Sens (FR)
(74) Mandataire: Renous Chan, Véronique

(57) **Abrégé**

L'invention concerne un dispositif support pour un dispositif d'éclairage et/ou de signalisation, notamment feu ou projecteur destiné à un véhicule automobile, comprenant un support de circuit conducteur (15) destiné à recevoir au moins une source lumineuse, et une plaque de renfort (16) destinée être fixée sur le circuit conducteur pour maintenir au moins une lame de contact sur le circuit conducteur. La plaque de renfort et le support de circuit conducteur forment une seule pièce.

## Description

La présente invention se rapporte au domaine des dispositifs support dans un dispositif d'éclairage et/ou de signalisation, notamment feu ou projecteur, destiné à un véhicule automobile.

Le domaine de l'invention est, d'une façon générale, celui des dispositifs d'éclairage et/ou de signalisation de véhicule automobile.

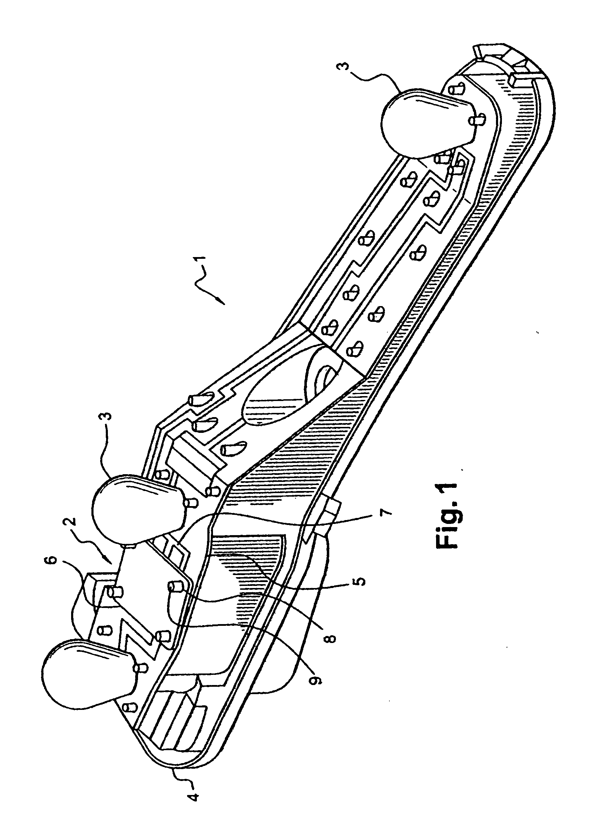

La figure 1 est une vue en perspective d'un feu de véhicule automobile pendant une opération d'assemblage, selon l'art antérieur.

Le feu 1 comprend une vitre extérieure non représentée, des sources lumineuses 3, un support de porte lampe 4 et un circuit conducteur 5 ou porte-lampe, destinée à recevoir les sources lumineuses 3.

Des lames de contact 7 sur le circuit conducteur 5 permettent de conduire l'électricité, entre autres pour alimenter les sources lumineuses 3.

Lorsqu'un tel feu est assemblé et monté dans un véhicule automobile, le circuit conducteur peut être soumise à des pressions relativement élevées. Les lames de contact risquent de se détacher du circuit conducteur sous l'effet de la pression. (On comprend ici par circuit conducteur l'ensemble du support du circuit et du circuit lui-même).

Il est connu de maintenir les lames de contact 7 contre le circuit conducteur 5 grâce à une plaque de renfort 6. La plaque de renfort 6 comprend des trous 8 et le circuit conducteur le circuit conducteur 5 comprend des pions de sertissage 9. Lors d'une opération d'assemblage de la plaque de renfort 6 sur le circuit conducteur 5, la plaque de renfort 6 est déposée sur le circuit conducteur 5 de telle sorte que chaque trou 8 reçoive un pion de sertissage 9 de le circuit conducteur le circuit conducteur 5, comme représenté sur la figure 1. La plaque de renfort 6 doit donc être au préalable positionnée relativement précisément par rapport à le circuit conducteur le circuit conducteur 5. La plaque de renfort 6 est par la suite sertie sur le circuit conducteur le circuit conducteur 5, de telle sorte que le circuit conducteur le circuit conducteur 5 et la plaque de renfort 6 forment un dispositif support 2. Le dispositif support 2 permet donc de recevoir les sources lumineuses 3 et les lames de contact 7, tout en étant capable de résister à des pressions relativement élevées, de l'ordre de grandeur de 100 Newtons. Un tel dispositif support est relativement complexe à fabriquer, du fait de la présence de la plaque de renfort. La fabrication des dispositifs support selon l'art antérieur nécessite en effet une étape de réalisation séparée de la plaque de renfort. Le stockage de la plaque de renfort doit également être géré.

La présente invention permet de simplifier un procédé de fabrication du dispositif support.

La présente invention a pour objet un dispositif support pour un dispositif d'éclairage et/ou de signalisation, notamment feu ou projecteur, destiné à un véhicule automobile. Le dispositif support comprend un support de circuit conducteur muni de circuit(s) conducteur(s), notamment métalliques et emboutis, et destiné à recevoir au moins une source lumineuse. Le dispositif support comprend également une plaque de renfort destinée à être fixée sur le support de circuit conducteur pour maintenir au moins une lame de contact sur le circuit conducteur. La plaque de renfort et le support de circuit conducteur forment avantageusement une seule pièce.

On comprend par support de circuit conducteur le support qui est muni de circuits conducteurs. On choisit le support de circuit généralement en un matériau à base de polymère(s) et présentant une certaine rigidité.

Le procédé de fabrication du dispositif support selon la présente invention est relativement simple : les étapes de réalisation séparée et de stockage de la plaque de renfort effectuées dans l'art antérieur sont ici supprimées.

Le dispositif support selon la présente invention est avantageusement réalisé en une seule pièce, par exemple par moulage.

La plaque support et la plaque de renfort comprennent avantageusement au moins une portion commune disposée au bord de la plaque de renfort. La portion commune permet avantageusement un repli de la plaque de renfort sur le circuit conducteur le circuit conducteur. Elle sert ainsi de « charnière provisoire » : on comprend sous ce terme qu'elle sert de charnière au moment de la fabrication du dispositif support, et qu'elle est destinée à rester ensuite sous cette forme repliée pendant la vie du produit.

Cette portion commune peut être continue, ou se présenter sous forme de charnières avec des zones discontinues : on peut ainsi réaliser une portion commune sous forme d'une ligne de matière discontinue, en pointillés.

La fabrication d'un tel dispositif support ne nécessite ainsi pas d'étape de positionnement de la plaque de renfort par rapport au support du circuit conducteur le circuit conducteur, comme dans l'art antérieur. La plaque de renfort est simplement repliée autour de la portion commune du support du circuit conducteur.

La présente invention n'est toutefois pas limitée par la forme de la plaque de renfort et de la plaque de support.

La plaque de renfort comprend avantageusement au moins une ouverture débouchant sur un de ses côtés.

Le dispositif support peut ainsi être moulé de telle sorte que la plaque de renfort soit sensiblement perpendiculaire au support du circuit conducteur, et en une seule opération.

La ou les ouvertures peuvent par exemple déboucher sur un côté opposé au côté de la portion commune et/ou sur le côté de la portion commune. L'intégrité de chaque ouverture est ainsi visible du côté de la portion commune ou bien du côté opposé : le démoulage peut ainsi être effectué suivant une seule direction et donc en une seule opération.

Alternativement, la plaque de renfort peut comprendre au moins une ouverture non débouchante : le démoulage de la plaque de renfort doit alors en général être effectué dans une direction sensiblement perpendiculaire à la plaque de renfort. Le moulage du dispositif support peut donc être effectué en une seule opération si la plaque de renfort est sensiblement parallèle à le circuit conducteur le circuit conducteur, ou bien en au moins deux opérations si la plaque de renfort est sensiblement perpendiculaire au circuit conducteur.

La présente invention n'est bien entendu pas limitée par les positions relatives de la plaque de renfort et du circuit conducteur après une opération de moulage.

La présente invention n'est pas non plus limitée par la présence, ni par la forme des ouvertures de la plaque de renfort.

La plaque support comprend avantageusement un pion de sertissage. Chaque ouverture de la plaque de renfort est avantageusement destinée à recevoir un pion de sertissage lorsque la plaque de renfort est repliée sur le circuit conducteur (ou réciproquement).

La plaque de renfort peut ainsi être sertie sur le support de circuit conducteur. La présente invention n'est toutefois pas limitée par la manière dont la plaque de renfort est fixée sur le support de circuit conducteur.

Le ou les pions de sertissage ont avantageusement une direction sensiblement perpendiculaire au support de circuit conducteur, mais la présente invention n'est pas limitée par la présence ni la par la forme des pions de sertissage.

En variante l'agencement peut être inverse c'est-à-dire que la plaque de renfort peut comprendre au moins un pion de sertissage, une ouverture du circuit conducteur étant destinée à recevoir un pion de sertissage lorsque la plaque de renfort est repliée sur le circuit conducteur

Le dispositif support est avantageusement à base de polymères (éventuellement chargés ou renforcés par des additifs minéraux ou organiques), comme du polypropylène, du polytéréphtalate de butylène ou de polyamide, mais tout autre matériau permettant de réaliser la plaque de renfort et le support de circuit conducteur en une seule pièce peut également être utilisé.

La présente invention a également pour objet un procédé de fabrication d'un dispositif support pour un dispositif de signalisation et/ou d'éclairage destiné à un véhicule automobile. Le dispositif support comprend un support de circuit conducteur pour recevoir au moins une source lumineuse. Le dispositif support comprend également une plaque de renfort permettant de maintenir au moins une lame de contact métallique sur le circuit conducteur. Le procédé selon la présente invention comprend une étape de moulage en une seule pièce de la plaque de renfort et du support de circuit conducteur. Le procédé de fabrication selon la présente invention comprend avantageusement une étape de repli de la plaque de renfort sur le support de circuit conducteur (ou réciproquement).

La plaque support est ainsi relativement dégagée avant le repli de la plaque de renfort, ce qui permet une manipulation aisée, par exemple pour poser les lames de contact sur le circuit conducteur. La plaque de renfort est ensuite repliée sur le support de circuit conducteur, permettant par là de maintenir les lames de contact posées au préalable.

Le procédé de fabrication selon la présente invention n'est toutefois pas limité par l'étape de repli.

Le procédé de fabrication selon la présente invention comprend avantageusement une étape de sertissage de la plaque de renfort sur le support de circuit conducteur (ou réciproquement). La présente invention n'est toutefois pas limitée par la manière dont la plaque de renfort est fixée sur le support de circuit conducteur. Tout autre mode de fixation mécanique, une fois la plaque de renfort repliée sur le support de circuit conducteur (ou réciproquement) est possible, comme un clippage, collage ....

Le procédé de fabrication conforme à l'invention peut être réalisé à l'aide d'un moule à démoulage direct : on comprend par là un moule par remoulage sans contre dépouille, un moule sans pièce mobile à l'intérieur dudit moule. On peut donc utiliser un moule simple à réaliser et à mettre en oeuvre.

La présente invention a également pour objet un dispositif de signalisation et/ou d'éclairage destiné à un véhicule automobile, comprenant un dispositif support selon la présente invention.

La présente invention a également pour objet un véhicule automobile comprenant un dispositif signalisation et/ou d'éclairage selon la présente invention.

L'invention est décrite ci-après plus en détail à l'aide de figures ne représentant qu'un mode de réalisation préféré non limitatif de l'invention.

La figure 1, déjà commentée, est une vue en perspective d'un feu de véhicule automobile pendant une opération d'assemblage, selon l'art antérieur.

Les figures 2A, 2B, 2C, 2D et 2E illustrent différentes étapes d'un exemple de procédé de fabrication d'un dispositif support selon un mode de réalisation préféré de la présente invention.

La figure 3 est une vue en coupe et en perspective d'un exemple de dispositif support selon le mode de réalisation préféré de la présente invention.

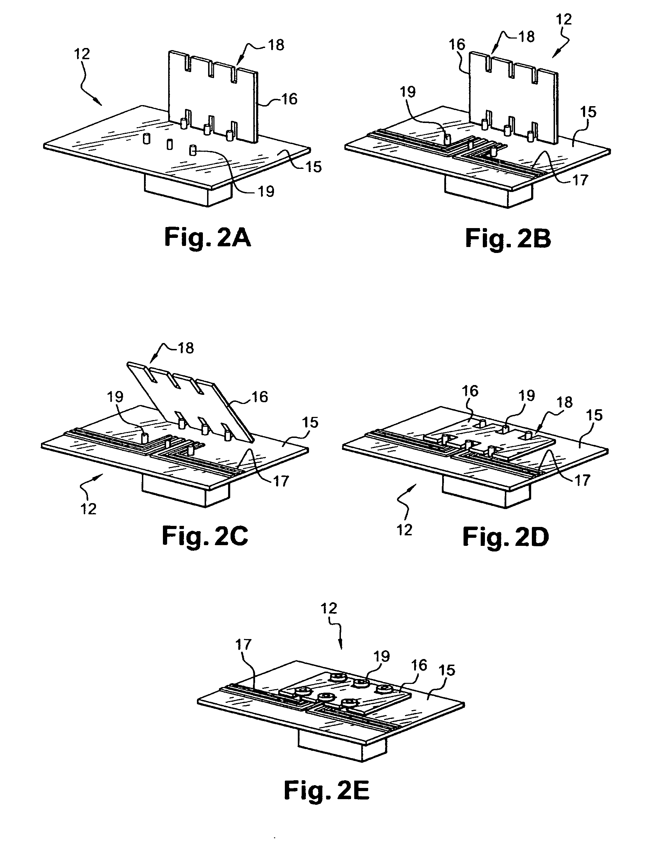

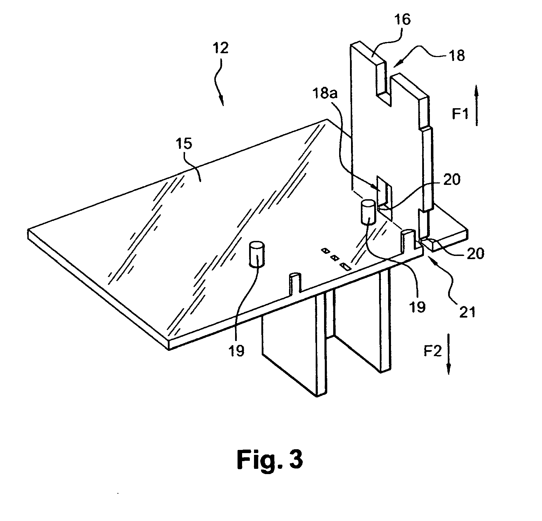

On notera que des éléments ou parties identiques ou similaires ont été désignés par les mêmes signes de référence sur les figures 2A, 2B, 2C, 2D, 2E et 3.

La figure 2A est une vue en perspective d'un exemple de dispositif support 12 selon la présente invention. Le dispositif support 12 comprend un support de circuit conducteur 15 et une plaque de renfort 16. Le support de circuit conducteur 15 et la plaque de renfort 16 sont réalisées par moulage, en une seule pièce.

La plaque de renfort 16 comprend des ouvertures 18 débouchant sur deux de ses côtés, le support de circuit conducteur 15 comprend des pions de sertissage 19.

Dans le mode de réalisation préféré de la présente invention, la plaque de renfort 16 est sensiblement perpendiculaire au circuit conducteur 15 après l'opération de moulage, le support de circuit conducteur 15 est ainsi relativement dégagé, de sorte que des lames de contact 17 peuvent aisément être posées sur le support de circuit conducteur 15, comme illustré sur la figure 2B.

Une fois les lames de contact 17 posées, la plaque de renfort 16 peut être repliée sur le support de circuit conducteur 15, comme illustré sur la figure 2C.

Les ouvertures 18 de la plaque de renfort 16 et les pions de sertissage 19 de le circuit conducteur 15 ont des positions telles que lorsque la plaque de renfort 16 est repliée sur le support de circuit conducteur 15, chaque ouverture 18 reçoive un pion de sertissage 19, comme l'illustre la figure 2D.

La plaque de renfort 16 est par la suite sertie sur le support de circuit conducteur 15. La figure 2E illustre un exemple de dispositif support après une opération de sertissage, selon le mode de réalisation préféré de la présente invention.

Dans le mode de réalisation préféré de la présente invention, les ouvertures 18 débouchent sur deux côtés opposés de la plaque de renfort 16. Après moulage de la plaque de renfort 16 et de la pièce support 15 en une seule pièce, la plaque de renfort 16 peut être sensiblement perpendiculaire au support de circuit conducteur 15, comme illustré sur la figure 3.

Le moulage du dispositif support 12 peut, dans le mode de réalisation préféré de la présente invention, être effectué en une seule opération, suivant la direction sensiblement indiquée sur la figure 3 par les flèches F₁ et F₂.

La plaque de renfort 16 et le support de circuit conducteur 15 ont au moins une portion commune 20. Le circuit conducteur 16 représenté sur la figure 3 comprend au moins une ouverture 18a débouchant sur le côté de la ou des portions communes 20, de sorte que le dispositif support 12 comprend en fait au moins deux portions communes 20. Chaque portion commune 20 est séparée de l'autre par l'ouverture 18a débouchant sur le côté des portions communes.

Dans le mode de réalisation préféré, chaque portion commune 20 comprend une fine couche de polypropylène reliant le reste de la plaque de renfort 16 au reste du circuit conducteur 15. La plaque de renfort 16 et le support de circuit conducteur 15 sont également réalisées en polypropylène, classiquement par moulage. Le matériau polypropylène est avantageux notamment car il se plie bien.

Les portions communes 20 sont situées au voisinage d'une partie évidée 21, de manière à permettre un repli de la plaque de renfort 16 relativement aisé.

Lors du repli de la plaque de renfort 16 sur le support circuit conducteur 15, la plaque de renfort 16 pivote sensiblement autour des portions communes 20.

Les portions communes 20 risquent de se rompre lors du repli : une fois fabriqué, le dispositif support 12 comprend alors la plaque de renfort 16 et le support de circuit conducteur 15, en deux pièces séparées. Les portions communes 20 permettent d'éviter une étape de positionnement de la plaque de renfort 16 sur le circuit conducteur 15. Même si les portions communes 20 sont rompues lors du repli, la plaque de renfort 16 est alors positionnée correctement et peut être sertie sur le support de circuit conducteur 15. La plaque de renfort 16 et le support de circuit conducteur 15 forment une seule pièce seulement pendant le procédé de fabrication du dispositif support 12.

Les portions communes 20 peuvent également ne pas rompre lors du repli : la plaque de renfort 16 et le support de circuit conducteur 15 restent alors d'une seule pièce, même une fois le dispositif support 12 fabriqué.

La présente invention n'est de manière générale pas limitée par la forme de la ou des portions communes, ni non plus par la forme des autres éléments du dispositif support, par exemple le circuit conducteur, la plaque de renfort, les lames de contact, les ouvertures, les pions de sertissage etc.

## Revendications

1. Dispositif support pour un dispositif d'éclairage et/ou de signalisation, notamment feu ou projecteur, destiné à un véhicule automobile, comprenant
un support de circuit conducteur (15) destiné à recevoir au moins une source lumineuse,
une plaque de renfort (16) destinée être fixée sur le circuit conducteur pour maintenir au moins une lame de contact (17) sur le circuit conducteur,
**caractérisé en ce que**
la plaque de renfort et le support de circuit conducteur forment une seule pièce.

2. Dispositif support selon la revendication 1,
**caractérisé en ce que** le support de circuit conducteur (15) supporte au moins un circuit conducteur, notamment sous forme de circuits métalliques emboutis.

3. Dispositif support selon la revendication 1 ou 2,
**caractérisé en ce que** le support de circuit conducteur (15) et la plaque de renfort (16) comprennent au moins une portion commune disposée au bord de la plaque de renfort, la portion commune permettant un repli de la plaque de renfort sur le support de circuit conducteur.

4. Dispositif support selon la revendication 3,
**caractérisé en ce que** la portion commune est une charnière provisoire.

5. Dispositif support selon l'une des revendications précédentes,
**caractérisé en ce que**,
la plaque de renfort comprend au moins une ouverture (18) débouchant sur un de ses côtés.

6. Dispositif support selon la revendication 5,
**caractérisé en ce que**
le support de circuit conducteur comprend au moins un pion de sertissage (19), chaque ouverture (18) de la plaque de renfort étant destinée à recevoir un pion de sertissage lorsque la plaque de renfort est repliée sur le support de circuit conducteur.

7. Dispositif support selon la revendication 3 ou 4,
**caractérisé en ce que**
la plaque de renfort comprend au moins un pion de sertissage, une ouverture du support de circuit conducteur étant destinée à recevoir un pion de sertissage lorsque la plaque de renfort est repliée sur le circuit conducteur.

8. Dispositif support selon l'une des revendications précédentes,
**caractérisé en ce que**
le support de circuit conducteur est à base de polypropylène, de polytéréphtatate de butylène ou de polyamide.

9. Procédé de fabrication d'un dispositif support pour un dispositif d'éclairage et/ou de signalisation, notamment feu ou projecteur, destiné à un véhicule automobile, le dispositif support comprenant
un support de circuit conducteur (15) pour recevoir au moins une source lumineuse, et
une plaque de renfort (16) permettant de maintenir au moins une lame de contact métallique (17) sur le support de circuit conducteur,
le procédé comprenant
une étape de moulage en une seule pièce de la plaque de renfort et du support de circuit conducteur.

10. Procédé de fabrication selon la revendication 9, comprenant par ailleurs une étape de repli de la plaque de renfort sur le support de circuit conducteur ou réciproquement.

11. Procédé de fabrication selon la revendication 9 ou la revendication 10, comprenant par ailleurs
une étape de sertissage ou collage ou clippage de la plaque de renfort repliée sur le support de circuit conducteur ou réciproquement.

12. Procédé de fabrication selon l'une des revendications 9 à 11, réalisé à l'aide d'un moule à démoulage direct.

13. Dispositif de signalisation et/ou d'éclairage, notamment pour véhicule automobile, comprenant un dispositif support selon l'une des revendications 1 à 8.
